# NEW EUROPEAN PATENT SPECIFICATION

(11) **EP 0 275 978 B2**
(45) Date of publication and mention of the opposition decision: **10.03.1999**
(45) Mention of the grant of the patent: 12.04.1995
(21) Application number: 88100691.0
(22) Date of filing: 19.01.1988
(51) Int. Cl.: C23C 16/30, C23C 28/04, C23C 16/02, C04B 41/50, B23B 27/14

(54) **A method for depositing composite coatings**
Verfahren zum Aufbringen von Verbundschichten
Procédé de déposition de revêtements composites

(30) Priority: 20.01.1987 US 5001; 20.01.1987 US 5003
(43) Date of publication of application: 27.07.1988
(73) Proprietor: VALENITE INC., Wilmington Delaware 19801 (US)
(72) Inventor: Sarin, Vinod K., Lexington, MA 02173 (US); Hintermann, Hans Erich, CH-3232 Ins (CH); Gindraux, Gilbert, CH-2000 Neuchatel (CH)
(74) Representative: Grünecker, Kinkeldey, Stockmair & Schwanhäusser Anwaltssozietät

(56) References cited:
- FR-A- 2 393 852
- GB-A- 1 275 044
- GB-A- 1 291 388
- GB-A- 1 408 193
- JP-A-57 039 168
- JP-A-61 201 778
- US-A- 4 052 530
- PATENT ABSTRACTS OF JAPAN, vol. 9, no. 12 (C-261)[1735], 18th January 1985;& JP-A-59 162 270 (SUMITOMO DENKI KOGYO K.K.) 13-09-1984
- PATENT ABSTRACTS OF JAPAN, vol. 9, no. 91 (C-277)[1814], 19th April 1985;& JP-A-59 222 570 (SUMITOMO DENKI KOGYO K.K.) 14-12-1984
- PATENT ABSTRACTS OF JAPAN, vol. 10, no. 303 (C-378)[2359], 16th October 1986;& JP-A-61 117 260 (NIPPON STEEL CORP.) 04-06-1986
- N.Claussen "Fracture Toughness of Al203 with an unstabilized Zr02 dispersed Phase", Journal of the American Ceramic Society, vol. 59, 1976, page 49

## Description

This invention relates to a method for depositing a wear-resistant coating on a cemented carbide or hard ceramic substrate, and more particularly to the deposition of a two or more phase composite oxide coating on such a substrate. Furthermore this invention relates to a wear resistant article.

FR-A-2 393 852, discloses a process for forming a thin wear-resistant coating consisting mainly of Al₂O₃ wherein approximately 85% of the Al₂O₃ is in the Kappa phase. In order to promote the formation of the Kappa phase, small amounts of titan, zirconium and/or hafnium can be added. Codeposition processes, as described in this prior art, will always result in a solid solution of two materials, for example, oxides. The prior art is silent on how discrete particles can be achieved. Furthermore, it fails to suggest the effectiveness of discrete particles in a wear-resistant coating.

Furthermore the abstract of JP-A-59222570 discloses the formation of a wear-resistant coating consisting of different layers. In contrast to its abstract, JP-A-59222570 only describes the formation of a one-layer coating consisting of Al₂O₃, ZrO₂ and/or HfO₂. while the coating is performed using the plasma CVD-method, the starting materials react with each other, for example, a doping of zirconium oxide or hafnium oxide will take place in the Al₂O₃ and thereby activating the surface diffusion of Al³⁺ in Al₂O₃. In the final product - the coating, the starting material will be maintained either in the form of a solid solution or of an appropriate mixture, wherein the different particles are not embedded discontinuously but continuously.

Cemented carbide and hard ceramic materials are known and are used extensively in such applications as mining tool bits, metal cutting and boring tools, metal drawing dies, wear-resistant machine parts and the like. Hard ceramic materials, as used herein refers to such compositions as Al₂O₃, Si₃N₄, silicon aluminum oxynitride and related compounds, as hard and dense monolithic or composite materials. The composites include those containing whiskers and/or particulates of SiC, Si₃N₄, other ceramic materials, and metal carbides, nitrides, and carbonitrides such as TiC and TiN. It is also known that the service properties such as wear, high temperature and chemical resistance of such materials may be enhanced by the application of one or more thin coatings of, for example, metal carbides, metal nitrides, or ceramics. Great strides have been made in improved performance of these coated substrates, for example in machining applications, by refinement of the substrate compositions and by applying various combinations of superimposed layers of coating materials. However, increasingly stringent use conditions, for example use at high cutting speeds or in extremely high temperatures and/or corrosive environments, are placing increasing demands upon the performance of such materials.

The object of the present application is to provide a process for depositing a wear-resistant composite coating of controlled composition and distribution on a cemented carbide or hard ceramic substrate and to provide an article consisting of this wear-resistant coating and cemented carbide or hard ceramic substrate showing improved abrasion resistance under extreme conditions of use.

This object is achieved in respect to the process by the subject matter of claim 1 and in respect to the article by the subject matter of claim 22.

An improved process for depositing a wear resistant ceramic coating on a cemented carbide or hard ceramic substrate according to one embodiment of the invention involves passing over the substrate a first gaseous mixture of a first halide vapor selected from the halides of aluminum, yttrium and zirconium, with other reactant gases, and optionally a carrier gas. The temperature is about 900°-1250°C for cemented carbide substrates, or about 900°-1500°C for hard ceramic substrates, and the pressure between about 1 torr and about ambient pressure. The partial pressure ratios, the flow rate, and the length of time is sufficient to deposit a continuous, fully dense, adherent, wear resistant layer of a material selected from the oxides of aluminum, zirconium, and yttrium about 0.1-20 microns thick on the substrate. At least one additional vapor selected from the halides of aluminum, zirconium, and yttrium is mixed with the first gaseous mixture. The additional metal halide vapor is different from the first halide vapor, and is mixed at a partial pressure selected to form at least one discontinuous additional phase, dispersed as discrete particles within the continuous oxide layer, of at least one material selected from the oxides of aluminum, zirconium and yttrium, to form a wear resistant composite ceramic layer on the substrate.

In a preferred process according to the invention, the additional metal halide vapor is mixed with the first mixture by intermittently, during the deposition of the continuous oxide layer, pulsing the additional vapor into the first gaseous mixture to mix therewith. Most preferably, a single-phase oxide portion is deposited before the two or more phase portion and/or the process is controlled to form a stratified composite in which two or more phase portions alternate with single-phase continuous oxide portions.

The process according to another preferred embodiment of the invention involves passing a halide vapor such as Cl₂ or HCl, optionally mixed with a carrier gas, over a mixture or alloy of two or more metals selected from aluminum, zirconium, yttrium, and their metal salts at about 250°-1250°C to form a first gaseous mixture comprising halides of two or more of aluminum, zirconium, and yttrium, and optionally the carrier gas. The first gaseous mixture is mixed with other reactant gases to form a second gaseous mixture. The second gaseous mixture is passed over the substrate at a temperature of about 900-1250°C for the cemented carbide substrate, or about 900°-1500°C for the hard ceramic substrate, and a pressure between about 1.33 mbar(1 torr) and about ambient pressure, to deposit a composite layer on the substrate. The other reactant gases, the flow rates of the gases, the surface areas and the ratio of the surface areas of the two or more metals, and the deposition time are selected so that the composite layer comprises an adherent layer about 0.1-20 microns thick of a continuous first phase of an oxide of one of the two or more of aluminum, zirconium, and yttrium, and one or more discontinuous additional phases, dispersed as discrete particle within the first-phase layer, of oxides of the remaining of the two or more of aluminum, zirconium, and yttrium.

Another preferred embodiment of the invention involves passing a first gaseous halide, optionally mixed with a first carrier gas, over a first metal selected from the group consisting of aluminum, zirconium, yttrium, and metal salts thereof, at about 250°-1250°C to form a gaseous first metal halide of aluminum, zirconium, or yttrium. A second gaseous halide, which may be the same or different from the first gaseous halide, optionally mixed with a second carrier gas, which may be the same or different from the first carrier gas, is passed over one or more additional metals selected from aluminum, zirconium, and yttrium, and alloys and metal salts thereof, and different from the first metal, at about 250°-1250°C to form additional metal halides of one or more of aluminum, zirconium, and yttrium. A gaseous mixture of the first metal halides and the one or more additional metal halides, optionally the carrier gases, and other reactant gases is passed over the substrate, at a temperature of about 900°-1250°C for the cemented carbide substrate, or about 900°-1500°C for the hard ceramic substrate, and at a pressure between about 1 torr and about ambient pressure, to deposit a composite layer on the substrate. The other reactant gases, the flow rates of the vapors, the surface areas of the first metal and the one or more additional metals, and the deposition time are selected so that the composite layer comprises an adherent layer about 0.1-20 microns thick of a continuous first phase of an oxide of one of aluminum, zirconium, and yttrium, having one or more discontinuous additional phases of discrete particles of oxide(s) of one or more of aluminum, zirconium, and yttrium dispersed therein, the additional phase oxide(s) being different from the first-phase oxide.

In yet another preferred embodiment of the process according to the invention, at least one intermediate layer about 0.5-10 microns thick selected from the group consisting of the carbides, nitrides, and carbonitrides of Ti, Zr, Hf, V, Nb, Ta, Cr, Mo, W, Si, and B is deposited between the substrate and the oxide layer.

In a process according to yet another embodiment of the invention, the step of passing the first halide over the first metal is a continuous step, producing a steady flow of the first metal halide to pass over the substrate, and the step of passing the second halide over the one or more additional metals is an intermittent, pulsing step, producing pulses of the one or more additional metal halide to pass over the substrate with the first metal halide, the second halide being pulsed at intervals and for times selected to control the size and distribution of the additional phase particles within the continuous first phase.

In the most preferred embodiment of the process according to the invention, the step of passing the gaseous mixture over the substrate takes place within a reactor, and at least one of the first metal and the one or more additional metals is disposed within a separate vessel within the reactor. The separate vessel operationally communicates with a source of the associated gaseous halide, and optionally the associated carrier gas, and with the reactor, so that the associated gaseous halide enters the separate vessel, passes over the surfaces of the metal or metals therein to form the metal halide, which flows into the reactor to pass over the substrate as a component of the gaseous mixture.

The invention will now be described in detail with reference to the accompanying drawings in which:

FIGURES 1 and 2 are schematic cross-sectional illustrations of substrates coated by two different embodiments of processes according to the invention.

FIGURE 3 is a bar graph of comparative machining results.

The process according to the present invention involves deposition of an adherent two or more phase composite oxide-based coating on a cemented metal carbide substrate, for example, a tungsten carbide-cobalt or related material, or on a hard ceramic material as described above.

The deposition of a two or more phase oxide-based composite coating which possesses the properties of adherence to the substrate, wear resistance, high temperature resistance and resistance to chemical attack or breakdown at high temperatures depends on careful control of the process parameters. The outstanding properties of the coating are a result of the achievement of a second phase of discrete particles of an Al₂O₃, ZrO₂ or Y₂O₃, or a combination of these, within an Al₂O₃, ZrO₂, or Y₂O₃ matrix. For example, the preferred coatings include ZrO₂ and/or Y₂O₃ particles within a continuous Al₂O₃ matrix, Y₂O₃ particles within a continuous ZrO₂ matrix, ZrO₂ particles within a continuous Y₂O₃ matrix, or Y₂O₃ stabilized ZrO₂ particles, i.e., an Y₂O₃-ZrO₂ solid solution, in a continuous Al₂O₃ matrix. The particles may be evenly distributed throughout the matrix, or their distribution may be controlled to achieve, for example, a stratified structure of single-phase oxide matrix portions alternating with two or more phase matrix/particle portions, preferably distributed at controlled intervals throughout the depth of the matrix. Similarly, the deposition may be controlled to deposit a single-phase continuous portion of controlled depth of the matrix material below the two or more phase portion or the alternating single-phase/two or more phase portion of the coating.

The process involves the use of a mixture of gases including a mixture of two or more metal halides and other reactant gases under carefully controlled conditions to deposit by chemical vapor deposition (CVD) compounds of the metals on a substrate. The metal halides preferably are produced by passing halide gas or gases over the metals, for example metal particulates. For example, the metals may be combined as a mixture of metals, as a metal alloy, or as metal salts. A single halide gas is passed over the combined metals to form a mixture of metal halides. Alternatively, at least the metal forming the matrix is separate, and separate halide gas streams are passed over the metals to form separate metal halides, which are later combined. Carrier gases, for example Ar, may be combined with the halide gases. Preferred halide gases are Cl₂ and HCl, forming with the metals described above AlCl₃, ZrCl₄, and/or YCl₃. These are combined with suitable other gases such as H₂ and CO₂ or other volatile oxidizing gases such as H₂O.

One or more of the metals may be advantageously contained in a separate vessel within the CVD reactor. The gas enters the reactor via the separate vessel, the halide gas being converted by contact with the metal therein to the desired metal halide, which then enters the reactor to pass over the substrate. This method presents the advantage of utilizing the temperature gradient within the reactor, which can be accurately controlled in a multiple zone furnace or by way of location within the reactor, to control the temperature of the halide-metal reaction. Thus different metals in separate vessels may be disposed at different zones or positions within the reactor to control the reaction temperature for each.

In order to achieve a first-phase matrix containing discrete particles of a second phase or phases, it is important to control the relative deposition by controlling such parameters as gas flow rates to produce the desired deposition of first and second phase materials.

Further control over the deposition process may be achieved by pulsing the metal halide gas forming the second phase or phases while maintaining continuous flow of the metal halide gas forming the matrix. This pulsing method may also be used to control the distribution of the second phase within the matrix, for example to achieve either an even distribution or a stratified distribution as described above.

Likewise, a single metal halide gas may be allowed to flow, with the other reactant gases, for a period of time sufficient to deposit a continuous single-phase portion of the material comprising the matrix, before the two-phase portion or alternating single-phase/two or more phase portion of the coating is deposited.

Some examples of composite coatings according to the invention are: Al₂O₃ matrix/ZrO₂ particles, ZrO₂ matrix/Y₂O₃ particles, Y₂O₃ matrix/ZrO₂ particles, Al₂O₃ matrix/Y₂O₃ stabilized ZrO₂ particles, Al₂O₃ matrix/Y₂O₃ particles, and Al₂O₃ matrix/ZrO₂ particles and Y₂O₃ particles.

The terms second phase and two-phase as used herein refer to composites comprising a first phase, continuous oxide matrix compound and one or more additional or second phases which may be a single compound or more than one compound, in the form of discrete particles. The particles may be oxides of a single metal or a solid solution of oxides of more than one metal, and the individual particles maybe of the same or different compounds. The particles disclosed herein may be regularly shaped, as spheres, rods, whiskers, etc., or irregularly shaped.

The composite coatings according to the invention are fully dense, adherent, and make it possible to combine the wear resistant properties of two or more components without the problems associated with differences in expansion coefficients and adhesion presented by layering of continuous coatings of the materials.

Further improvement in the adhesion of the coating to the substrate may be achieved by depositing between the composite coating and the substrate a thin intermediate layer of TiC, TiN, or other carbide, nitride or carbonitride of Ti, Zr, Hf, V, Nb, Ta, Cr, Mo, W, Si or B. Such deposition may be achieved in known manner as a preliminary part of the same coating process or in a separate, prior coating process. Similarly, for special applications, for example friction, cosmetic, wear or thermal purposes, a thin outer layer such as TiN may be applied in known manner over the composite coating.

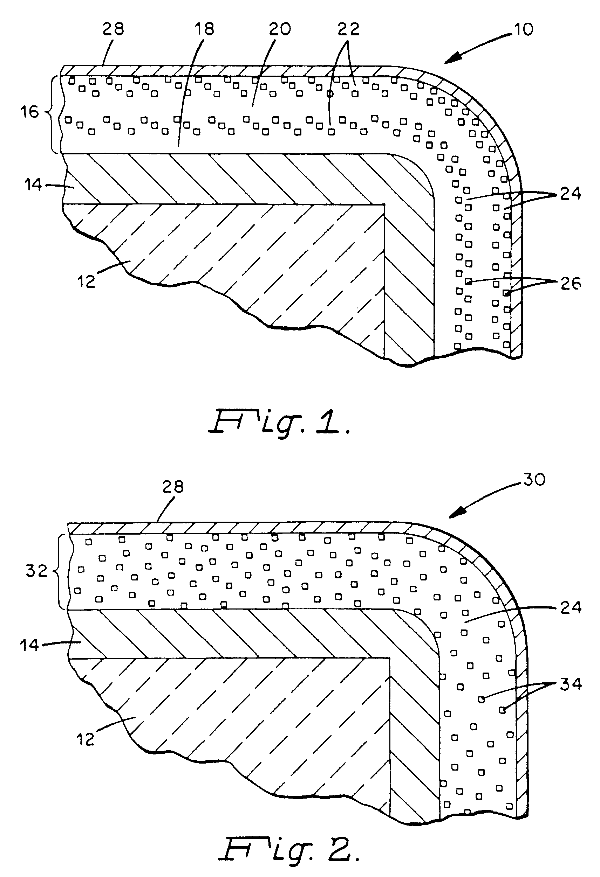

Figures 1 and 2, not drawn to scale, schematically illustrate typical articles 10 and 30 coated according to the invention. As shown in Figure 1, substrate 12 is a shaped cemented WC material, and may be a cutting tool or other article requiring wear resistance under the extreme conditions described above. A thin layer 14 of TiC covers the substrate, at least in the area subjected to wear. Composite layer 16 is deposited over TiC layer 14, and is made up of single-phase matrix portions 18 and 20 of Al₂O₃, and two-phase portions 22 of an Al₂O₃ matrix 24 and discrete particles 26 of ZrO₂. As shown in Figure 1, there is no separation between the Al₂O₃ of matrix 24 of two-phase portions 22 and that of single-phase matrix portions 18 and 20. The Al₂O₃ of the composite coating is a single continuous matrix having a second phase of controlled composition and distribution dispersed therein. An outer layer 28 of TiN is deposited over the composite layer, giving article 10 a distinctive identifying color.

Figure 2 illustrates an alternate embodiment of the article coated according to the invention. Like features in the two figures are identified by the same reference numerals. In Figure 2, substrate 12 is overlaid with thin TiC layer 14 in the same manner as shown in Figure 1. Composite layer 32 is deposited over TiC layer 14, and is made up of Al₂O₃ matrix 24 with particles 34 of Y₂O₃ stabilized ZrO₂ evenly distributed throughout matrix 24. Outer layer 28 of TiN is deposited over the composite layer.

### EXAMPLES 1-6

After rinsing of all gas lines with their respective gases for 0.5-1 hr, samples of cutting tool inserts of a cemented carbide material, steel cutting grade C-5, were coated with a layer of TiC about 3 microns thick by known techniques in a CVD reactor. An excess of preweighed zirconium metal chips was placed in a separate vessel disposed in the reactor. An excess of aluminum chips was placed in a vessel outside the reactor. The reactor was evacuated to about 13.3 mbar(10 torr), then heated under low pressure, while being flushed with flowing hydrogen, to increase the outgassing before deposition. Following the deposition procedure, the reactor was cooled, at the deposition pressure and while being flushed with hydrogen, to about 300°C, then under ambient pressure and flowing nitrogen to room temperature.

The deposition reaction conditions for Examples 1-6 are given in Table I, below. For all of these Examples the halide gas was Cl₂, the carrier gas for the Al and Zr reactions was Ar, and the other reactant gas was CO₂ with H₂ as a carrier. The Cl₂ flow rates were adjusted to give the metal chloride flow rates shown in Table I. The deposition pressure for Examples 1-6 was 66.5 mbar(50 torr); the temperature, 1040°C. For each of these Examples, a period of Al₂O₃ deposition (single-phase) ranging from 0.5 to 2.5 hrs was carried out before the two-phase Al₂O₃/ZrO₂ deposition was begun. During the single-phase deposition Ar gas was allowed to flow over the Zr, but the Cl₂ gas flow was shut off.

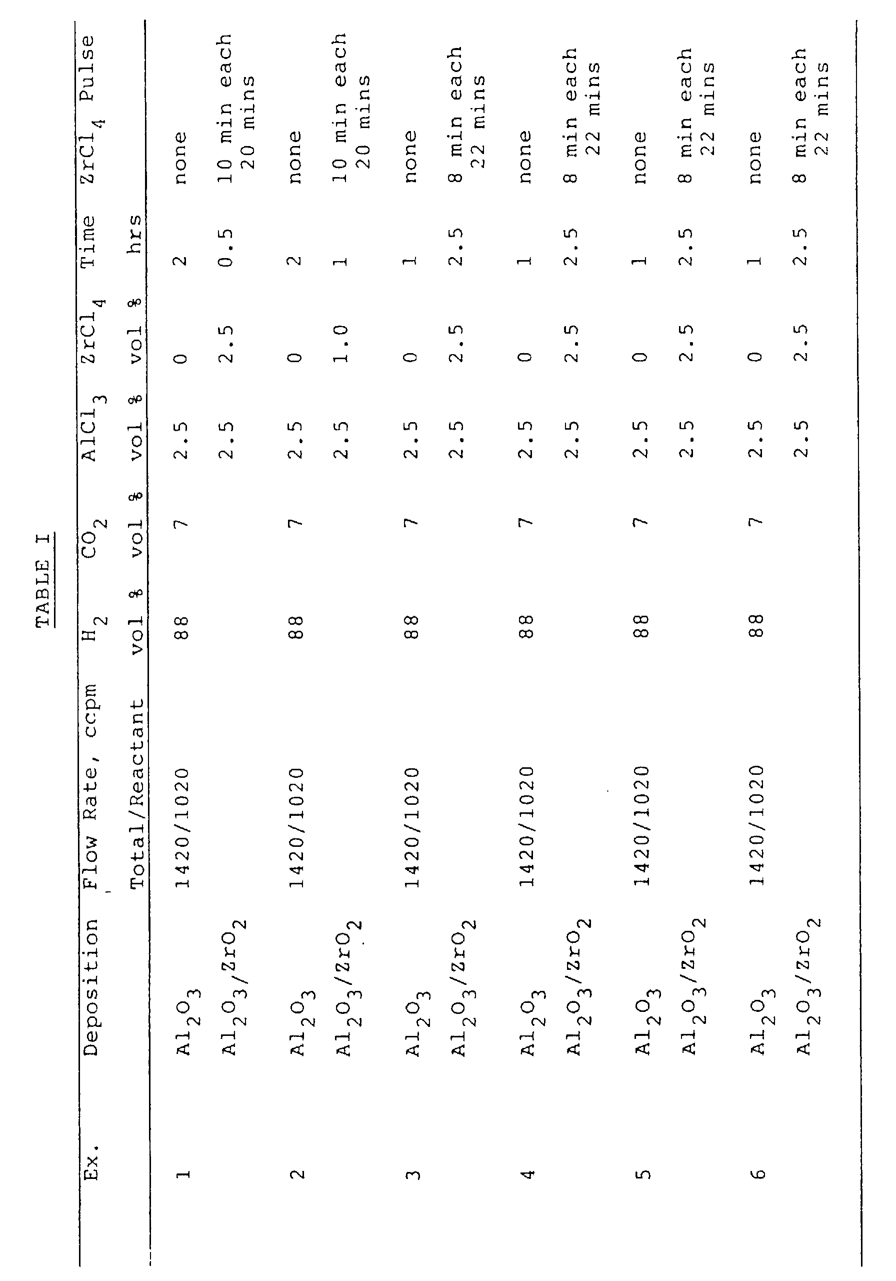

The results of Examples 1-6 are shown in Table II. The thickness of the coatings was measured by the abrasive ball method (Calotest). The chemical composition of the coating was determined by x-ray diffraction analysis. The coating was deposited on the TiC underlayer as a stratified composite of alternating alumina and alumina/zirconia portions over a single-phase alumina portion, similar to that illustrated in Figure 1, but without the TiN layer over the oxide coating. The oxide coating and the TiC underlayer show satisfactory thickness and good adherence.

**TABLE II**

| Example | Oxides thickness, microns | X-Ray Diffraction |
|---|---|---|
| 1 | --- | α - Al₂O₃ + ZrO₂ |
| 2 | 1.8 | α - Al₂O₃ + ZrO₂ |
| 3 | 5 | α - Al₂O₃ + ZrO₂ |
| 4 | 0.5-2 | α - Al₂O₃ + ZrO₂ |
| 5 | 0.7-1.5 | α - Al₂O₃ + ZrO₂ |
| 6 | 1.5 | α - Al₂O₃ + ZrO₂ |

Machining tests were performed on the coated cemented carbide cutting tool insert samples of Example 6 (A) and, for comparison, on a ceramic based insert (B), and on two different commercial grades of TiC based inserts coated with Al₂O₃ (C and D).

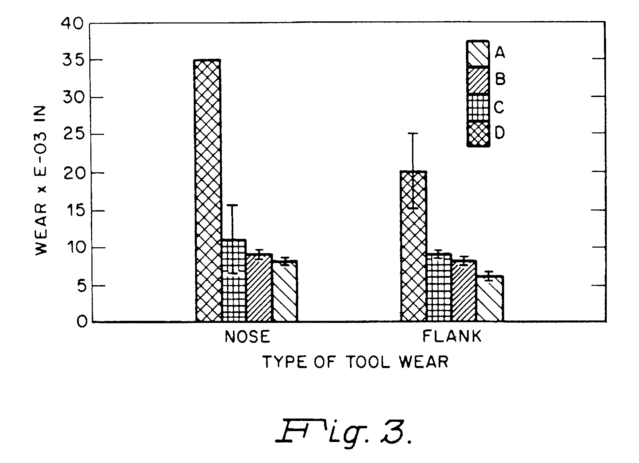

Inserts A, B, C and D were tested by turning a 4340 steel workpiece under dry conditions at 213 surface meter per minute (700 sfm), 0.254 min per revolution (0.01 ipr), 0.5 in DOC. For each insert, 458.9 cm³(28 cu. in.) of metal were removed in 6.7 min cutting time. The results are illustrated in Fig. 3, showing the average nose and flank wear for each type of insert. The inserts coated by the method according to the invention compared favorably with the materials in current commercial use.

### EXAMPLES 7-8

The process of Examples 1-6 was repeated for Examples 7 and 8, to coat the same type of TiC coated cemented carbide cutting tool inserts, except that both AlCl₃ and ZrCl₄ were flowing during the entire deposition period. The deposition pressure and temperature were 66.5 mbar(50 torr) and 1040°C respectively. The remaining reaction conditions are given in Table III below. The resulting composite coatings were similar to that illustrated in Figure 2, except that no TiN layer was deposited over the oxide coating. The coating was a continuous ZrO₂ matrix with Y₂O₃ particles distributed therein. No single phase portion was deposited below the two phase portion of the oxide layer.

**TABLE III**

| Ex. | Flow Rate ccpm Total/Reactant | Volume percents | | | | Time hrs. |
|---|---|---|---|---|---|---|
| | | H₂ | CO₂ | AlCl₂ | ZrCl₄ | |
| 7 | 1420/1020 | 65.7 | 29.3 | 2.5 | 2.5 | 2.8 |
| 8 | 1100/800 | 88 | 7 | 2.5 | 2.5 | 3 |

The processes described in Examples 1-8 are also useful for applying similar coatings to hard ceramic substrates to produce similar cutting inserts.

## Claims

1. A process for depositing a wear resistant ceramic coating on a cemented carbide or hard ceramic substrate using thermal vapor desposition comprising the steps of:
passing over the substrate a first gaseous mixture of a first halide vapor selected from the group consisting of halides of aluminum, yttrium and zirconium, with other reactant gases, and optionally a carrier gas, at a temperature of about 900°-1250°C for the cemented carbide substrate, or about 900°-1500°C for the hard ceramic substrate, at a pressure between about 1.33 mbar (1 Torr) and about ambient pressure, and at partial pressure ratios, at a flow rate, and for a time sufficient to deposite a continuous, fully dense, adherent, wear resistant layer of a material selected from the group consisting of oxides of aluminum, zirconium, and yttrium about 0.1-20 microns thick on the substrate;
which additionally comprises the step of:
mixing with the first gaseous mixture at least one additional vapor selected from the halides of aluminum, zirconium, and yttrium;
wherein the additional vapor is different from the first halide vapor, and is mixed at a partial pressure selected to form at least one discontinuous additional phase, dispersed as discrete particles within the continuous oxide layer, of at least one material selected from the group consisting of oxides of aluminum, zirconium, and yttrium, to form a wear resistant composite ceramic layer on the substrate.

2. A process according to claim 1 further comprising the step of depositing between the substrate and the composite ceramic layer at least one intermediate layer about 0.5-10 microns thick selected from the group consisting of carbides, nitrides, and carbonitrides of Ti, Zr, Hf, V, Nb, Ta, Cr, Mo, W, Si and B.

3. A process according to claim 1, wherein the additional vapor is pulsed into the first gaseous mixture, to mix therewith, during the deposition of the continuous oxide layer, and where the additional vapor is selected from the halide of aluminum, zirconium and yttrium, optionally mixed with a carrier gas.

4. A process according to claim 3 further comprising the step of controlling the size and distribution within the oxide layer of the additional phase particles by controlling the partial pressure, the time intervals, and the lengths of time at which the at least one additional vapor is pulsed into the first gaseous mixture.

5. A process according to claim 4 wherein the step of deposition of the continuous oxide layer is carried out for a sufficient time before the pulsing step is begun to form a single-phase, continuous oxide portion separating the substrate and the two or more phase portion of the composite ceramic coating.

6. A process according to claim 4 wherein the intermittent pulsing step occurs at time intervals and for times selected to form a stratified composite ceramic layer in which two or more phase portions alternate with single- phase, continuous oxide portions.

7. A process according to claim 3 further comprising the step of depositing between the substrate and the composite ceramic layer at least one intermediate layer about 0.5-10 microns thick selected from the group consisting of carbides, nitrides, and carbonitrides of Ti, Zr, Hf, V, Nb, Ta, Cr, Mo, W, Si and B.

8. A process according to claim 3 further comprising the step of depositing between the substrate and the composite ceramic layer an intermediate layer of TiC or TiN about 2-5 microns thick; and wherein the first gaseous mixture consists essentially of 2.5-21 volume % CO₂, 47-64 volume % hydrogen, and 1.5-30 volume % AlCl₃, the remainder being argon, passing over the substrate at a temperature of 1000-1100°C, a pressure of 66.5-133 mbar (50-100 torr), and a flow rate of 1100-1500 cm³/min for 2.5 to 5 hr; and the at least one additional vapor is 0.5-2.5 volume % ZrCl₄ pulsed for about 1-10 min at intervals of about 2-6 times the pulse time, to deposit a composite ceramic layer consisting of a first, continuous phase of Al₂O₃ and a discontinuous additional phase of discrete grains of ZrO₂ dispersed within the Al₂O₃ first phase.

9. A process according to claim 8 wherein the intermediate layer is TiC about 3.0-3.5 microns thick; the first gaseous mixture consists essentially of about 7 volume % CO₂, 88 volume % hydrogen, 2.5 volume % AlCl₃, the remainder being argon, passing over the substrate at a temperature of about 1040°C, a pressure of about 66.5 mbar (50 torr), and a flow rate of about 1420 cm³/min for about 3.5 hrs; and about 2.5 volume % ZrCl₄ is pulsed for about 8 min of each 22 min during the last 2.5 hrs.

10. A process according to claim 1 further comprising the steps of:
passing a halide vapor, optionally mixed with a carrier gas, over a mixture or alloy of two or more metals selected from the group consisting of aluminum, zirconium, yttrium and their metal salts, at about 250°-1250°C, to form a first halide mixture comprising halides of two or more of aluminum, zirconium, and yttrium, and optionally the carrier gas; and
mixing the first halide mixture with other reactant gases to form a first gaseous mixture.

11. A method according to claim 10 wherein the mixture or alloy of two or more metals consists essentially of a mixture or alloy of aluminum and zirconium or a mixture or alloy of zirconium and yttrium; the other reactant gases comprise CO₂ with hydrogen as a carrier; and the composite layer comprises a continuous Al₂O₃ first phase having discrete particles of ZrO₂ dispersed therein, or a continuous ZrO₂ first phase having discrete particles of Y₂O₃ dispersed therein, or a continuous Y₂O₃ first phase having discrete particles of ZrO₂ dispersed therein.

12. A process according to claim 10 further comprising the step of depositing between the substrate and the composite ceramic layer at least one intermediate layer about 0.5-10 microns thick selected from the group consisting of the carbides, nitrides, and carbonitrides of Ti, Zr, Hf, V, Nb, Ta, Cr, Mo, W, Si, and B.

13. A process according to claim 1 further comprising the steps of:
first passing a first gaseous halide, optionally mixed with a first carrier gas, over a first metal selected from the group consisting of aluminum, zirconium, yttrium, and metal salts thereof, at 250°-1250°C, to form a gaseous first metal halide of aluminum, zirconium, or yttrium; and
passing a second gaseous halide, which may be the same or different from the first gaseous halide, optionally mixed with a second carrier gas, which may be the same or different from the first carrier gas, over one or more additional metals selected from the group consisting of aluminum, zirconium, yttrium, and alloys and metal salts thereof, and different from the first metal, at about 250°-1250°C, to form one or more additional metal halides of one or more of aluminum, zirconium, and yttrium.

14. A process according to claim 13 further comprsing the step of depositing between the substrate and the oxide layer at least one intermediate layer about 0.5-10 microns thick selected from the group consisting of the carbides, nitrides, and carbonitrides of Ti, Zr, Hf, V, Nb, Ta, Cr, Mo, W, Si, and B.

15. A process according to claim 14 wherein the first metal is aluminum, the additional metal is zirconium, the first and second halides are both Cl₂ or HCl, and the intermediate layer is TiC.

16. A process according to claim 15 wherein the step of passing the first halide over the first metal is a continuous step, producing a steady flow of the first metal halide to pass over the substrate; and the step of passing the second halide over the one or more additional metals is an intermittent, pulsing step, producing pulses of the one or more additional metal halides to pass over the substrate with the first metal halide, wherein the second halide is pulsed at intervals and for times selected to control the size and distribution of the additional phase particles within the continuous first phase.

17. A process according to claim 13 wherein the first metal halide and the other reactant gases are passed over the substrate for a sufficient time before the flow of the second halide is begun to deposit a single-phase, continuous portion of the composite layer separating the substrate and the two or more phase portion of the composite layer.

18. A process according to claim 13 wherein the step of passing the gaseous mixture over the substrate takes place within a reactor; and at least one of the first metal and the one or more additional metals is disposed within a separate vessel within the reactor, the separate vessel operationally communicating with a source of the associated gaseous halide, and optionally the associated carrier gas, and with the reactor, so that the associated gaseous halide enters the separate vessel, and passes over the metal(s) therein to form the metal halide(s), which flows into the reactor to pass over the substrate as a component of the gaseous mixture.

19. A process according to claim 18 wherein the first metal is aluminum or a metal salt thereof; and the one or more additional metals is zirconium or yttrium, or a metal salt thereof, or a mixture or alloy thereof, and is disposed within a separate vessel within the reactor.

20. A process according to claim 13 wherein the additional metal is aluminum, zirconium, yttrium or a metal salt thereof, and is different from the first metal; and further comprising the step of passing a third gaseous halide, which may be the same or different from the first and second gaseous halides, optionally mixed with a third carrier gas, which may be the same or different from the first and second carrier gases, over a third metal selected from the group consisting of aluminum, zirconium, yttrium, and metal salts thereof, and different from the first and additional metals, at about 250°-1250°C, to form a third metal halide of aluminum, zirconium, or yttrium; and wherein the gaseous mixture passing over the substrate further comprises the third metal halide, and the discontinuous additional phase further comprises discrete particles of oxides of two of aluminum, zirconium, and yttrium dispersed therein.

21. A process according to claim 20 wherein the step of passing the gaseous mixture over the substrate takes place within a reactor; and at least one of the first metal, the additional metal, and the third metal is disposed within a separate vessel within the reactor, the separate vessel operationally communicating with a source of the associated gaseous halide and optionally the associated carrier gas, and with the reactor, so that the associated gaseous halide enters the separate vessel, and passes over the metal therein to form the metal halide, which flows into the reactor to pass over the substrate as a component of the gaseous mixture.

22. A wear resistant article comprising:
a cemented carbide or hard ceramic substrate body, and
a fully dense, adherent, wear resistant, composite ceramic coating having at least two phases on the substrate comprising:
a continous oxide layer about 0.1-20 microns thick of a material selected from the group consisting of the oxides of aluminium, zirconium, and yttrium; and
at least one discontinous additional phase dispersed as disrete particles within the oxide layer, of at least one material selected from the group consisting of oxides of aluminium, zirconium, and yttrium, the least one material being different from that of the oxide layer;
characterized in that
the composite ceramic layer is a stratified layer in which portions having at least two phases alternate with single phase continous oxide portions.

23. An article according to claim 22, wherein the substrate body is a Si₃N₄-based composite, the continous oxide layer is Al₂O₃ and the additional phase is ZrO₂ particles dispersed within the Al₂O₃ to form two-phase Al₂O₃ / ZrO₂ portions alternating with single-phase continous Al₂O₃ portions, and further comprising, between the substrate body and the composite ceramic layer, an intermediate layer of TiC about 2 - 5 microns thick.

24. A wear resistant article comprising:
a cemented carbide or hard ceramic substrate body, and
a fully dense, adherent, wear resistant, composite ceramic coating having at least two phases on the substrate comprising:
a continous oxide layer about 0.1 - 20 microns thick of a material selected from the group consisting of the oxides of aluminium, zirconium, and yttrium; and
at least one discontinous additional phase dispersed as disrete particles within the oxide layer, of at least one material selected from the group consisting of oxides of aluminium, zirconium, and yttrium, the least one material being different from that of the oxide layer;
characterized in that
the continous oxide layer is ZrO₂ and the additional phase is Y₂O₃.

25. A wear resistant article comprising:
a cemented carbide or hard ceramic substrate body, and
a fully dense, adherent, wear resistant, composite ceramic coating having at least two phases on the substrate comprising:
a continous oxide layer about 0.1-20 microns thick of a material selected from the group consisting of the oxides of aluminium, zirconium, and yttrium; and
at least one discontinous additional phase dispersed as disrete particles within the oxide layer, of at least one material selected from the group consisting of oxides of aluminium, zirconium, and yttrium, the least one material being different from that of the oxide layer;
characterized in that
the continous oxide layer is Y₂O₃ and the additional phase is ZrO₂.

26. A wear resistant article comprising:
a cemented carbide or hard ceramic substrate body, and
a fully dense, adherent, wear resistant, composite ceramic coating having at least two phases on the substrate comprising:
a continous oxide layer about 0.1 - 20 microns thick of a material selected from the group consisting of the oxides of aluminium, zirconium, and yttrium; and
at least one discontinous additional phase dispersed as disrete particles within the oxide layer, of at least one material selected from the group consisting of oxides of aluminium, zirconium, and yttrium, the least one material being different from that of the oxide layer;
characterized in that
the continous oxide layer is Al₂O₃ and the additional phase is Y₂O₃ stabilized ZrO₂.

27. A wear resistant article comprising:
a cemented carbide or hard ceramic substrate body, and
a fully dense, adherent, wear resistant, composite ceramic coating having at least two phases on the substrate comprising:
a continous oxide layer about 0.1 - 20 microns thick of a material selected from the group consisting of the oxides of aluminium, zirconium, and yttrium; and
at least one discontinous additional phase dispersed as disrete particles within the oxide layer, of at least one material selected from the group consisting of oxides of aluminium, zirconium, and yttrium, the least one material being different from that of the oxide layer;
characterized in that
the continous oxide layer is Al₂O₃ and the additional phases are Y₂O₃ and ZrO₂ particles.

## Patentansprüche

1. Verfahren zum Aufbringen von verschleißbeständigen keramischen Schichten auf ein Sintercarbid- oder Hartkeramiksubstrat unter Verwendung von thermischer Dampfab-scheidung, umfassend die folgenden Schritte:
Leiten einer ersten gasförmigen Mischung eines ersten Halogeniddampfes ausgewählt aus der Gruppe bestehend aus Aluminium-, Yttrium- und Zirkoniumhalogeniden, mit anderen Reaktionsgasen, und wahlweise mit einem Trägergas über das Substrat, bei einer Temperatur von ungefähr 900°-1250°C für das Sintercarbidsubstrat, oder von ungefähr 900°-1500°C für das Hartkeramiksubstrat, bei einem Druck zwischen ungefähr 1,33 mbar (1 Torr) und ungefähr Umgebungsdruck und bei Partialdruckverhältnissen, bei einer Durchflußgeschwindigkeit, und für einen ausreichenden Zeitraum um eine kontinuierliche, vollständig dichte, haftende, verschleißbeständige Schicht mit einer Dicke von ungefähr 0,1-20 Mikron auf dem Substrat abzuscheiden, bestehend aus einem Material ausgewählt aus der Gruppe bestehend aus Aluminium-, Zirkonium- und Yttriumoxiden;
zusätzlich umfassend den folgenden Schritt:
Vermischen der ersten gasförmigen Mischung mit wenigstens einem zusätzlichen Dampf ausgewählt aus Aluminium-, Zirkonium- und Yttriumhalogeniden;
wobei sich der zusätzliche Dampf von dem ersten Halogeniddampf unterscheidet, und bei einem Partialdruck vermischt wird, ausgewählt um wenigstens eine diskontinuierliche zusätzliche Phase zu bilden, welche als diskrete Teilchen in der kontinuierlichen Oxidschicht dispergiert ist, aus wenigstens einem Material ausgewählt aus der Gruppe bestehend aus Aluminium-, Zirkonium- und Yttriumoxiden, um auf dem Substrat eine verschleißbeständige keramische Verbundschicht zu bilden.

2. Verfahren nach Anspruch 1, des weiteren umfassend den Schritt des Abscheidens wenigstens einer etwa 0,5-10 Mikron dicken Zwischenschicht, ausgewählt aus der Gruppe bestehend aus Carbiden, Nitriden und Carbonitriden von Ti, Zr, Hf, V, Nb, Ta, Cr, Mo, W, Si und B zwischen dem Substrat und der keramischen Verbundschicht.

3. Verfahren nach Anspruch 1, wobei der zusätzliche Dampf während der Abscheidung der kontinuierlichen Oxidschicht in die erste gasförmige Mischung gepulst (pulsed) wird, um sich mit dieser zu vermischen, und wobei der zusätzliche Dampf aus Aluminium-, Zirkonium- und Yttriumhalogeniden ausgewählt und wahlweise mit einem Trägergas gemischt wird.

4. Verfahren nach Anspruch 3, des weiteren umfassend den Schritt des Steuerns der Größe und der Verteilung der zusätzlichen Phasenteilchen innerhalb der Oxidschicht, dadurch daß der Partialdruck, die Zeitintervalle, und die Zeiträume in denen wenigstens ein zusätzlicher Dampf in die erste gasförmige Mischung gepulst wird, gesteuert werden.

5. Verfahren nach Anspruch 4, wobei der Schritt des Abscheidens der kontinuierlichen Oxidschicht vor dem Beginn des Pulsschrittes über einen ausreichenden Zeitraum durchgeführt wird, um einen einphasigen, kontinuierlichen Oxidbereich zu bilden, der das Substrat und zwei oder mehrere Phasenbereiche der keramischen Verbundschicht abtrennt.

6. Verfahren nach Anspruch 4, wobei der diskontinuierliche Pulsschritt in Zeitintervallen und über Zeiträume auftritt, die ausgewählt sind, um eine schichtförmige keramische Verbundschicht zu bilden, wobei zwei oder mehrere Phasenbereiche mit einphasigen kontinuierlichen Oxidbereichen alternieren.

7. Verfahren nach Anspruch 3, des weiteren umfassend den Schritt des Abscheidens wenigstens einer etwa 0,5-10 Mikron dicken Zwischenschicht ausgewählt aus der Gruppe bestehend aus Carbiden, Nitriden und Carbonitriden von Ti, Zr, Hf, V, Nb, Ta, Cr, Mo, W, Si und B zwischen dem Substrat und der keramischen Verbundschicht.

8. Verfahren nach Anspruch 3, des weiteren umfassend den Schritt des Abscheidens einer ungefähr 2-5 Mikron dicken Zwischenschicht aus TiC oder TiN zwischen dem Substrat und der keramischen Verbundschicht; und wobei die erste gasförmige Mischung im wesentlichen aus 2,5- 21 Vol.-% CO₂, 47-64 Vol.-% Wasserstoff und 1,5-30 Vol.-% AlCl₃, Rest Argon besteht, und bei einer Temperatur von 1000-11000C, einem Druck von 66,5-133 mbar (50-100 torr) und einer Durchflußgeschwindigkeit von 1100-1500 cm³/min für 2,5-5 h über das Substrat geleitet wird; und wobei wenigstens ein zusätzlicher Dampf mit 0,5-2,5 Vol.-% ZrCl₄ ungefähr 1-10 min in Intervallen von etwa 2-5 mal der Pulszeit pulsiert wird, um eine keramische Verbundschicht abzuscheiden, bestehend aus einer ersten kontinuierlichen Phase aus Al₂O₃ und einer zusätzlichen diskontinuierlichen Phase aus diskreten Körner aus ZrO₂, die in der ersten Al₂O₃ Phase dispergiert sind.

9. Verfahren nach Anspruch 8, wobei die Zwischenschicht ungefähr 3,0-3,5 Mikron dickes TiC ist; die erste gasförmige Mischung im wesentlichen aus ungefähr 7 Vol.-% CO₂, 88 Vol.-% Wasserstoff, 2,5 Vol.-% AlCl₃, Rest Argon besteht, und bei einer Temperatur von ungefähr 1040°C, einem Druck von ungefähr 66,5 mbar (50 torr) und einer Durchflußgeschwindigkeit von ungefähr 1420 cm3/min für ungefähr 3,5 h über das Substrat geleitet wird; und ungefähr 2,5 Vol.-% ZrCl₄ ungefähr 8 min jede 22 min während der letzten 2,5 h pulsiert wird.

10. Verfahren nach Anspruch 1, des weiteren umfassend die folgenden Schritte:
Leiten eines Halogeniddampfes, wahlweise gemischt mit einem Trägergas, über eine Mischung oder eine Legierung von zwei oder mehreren Metallenl ausgewählt aus der Gruppe bestehend aus Aluminium, Zirkonium,Yttrium und deren Metallsalze, bei ungefähr 250°C-12500°C, um eine erste Halogenidmischung umfassend Halogenide von zwei oder mehreren ausgewählt aus Aluminium, Zirkonium und Yttrium und wahlweise das Trägergas zu bilden; und Mischen der ersten Halogenidmischung mit anderen Reaktionsgasen um die erste gasförmige Mischung zu bilden.

11. Verfahren nach Anspruch 10, wobei die Mischung oder Legierung von zwei oder mehreren Metallen im wesentlichen aus einer Mischung oder Legierung aus Aluminium und Zirkonium oder einer Mischung oder Legierung aus Zirkonium und Yttrium besteht; die anderen Reaktionsgase CO₂ umfassen, mit Wasserstoff als einem Träger; und wobei die Verbundschicht eine kontinuierliche erste Al₂O₃ Phase mit in dieser verteilten ZrO₂ Teilchen umfaßt, oder eine kontinuierliche erste ZnO₂ Phase mit in dieser verteilten diskreten Y₂O₃ Teilchen, oder eine kontinuierliche erste Y₂O₃ Phase mit in dieser verteilten diskreten ZrO₂ Teilchen.

12. Verfahren nach Anspruch 10, des weiteren umfassend den Schritt des Abscheidens wenigstens einer etwa 0,5-10 Mikron dicken Zwischenschicht, ausgewählt aus der Gruppe bestehend aus Carbiden, Nitriden und Carbonitriden von Ti, Zr, Hf, V, Nb, Ta, Cr, Mo, W, Si und B zwischen dem Substrat und der keramischen Verbundschicht.

13. Verfahren gemäß Anspruch 1, des weiteren umfassend folgende Schritte:
erstes Leiten eines ersten gasförmigen Halogenids, wahlweise gemischt nit einem ersten Trägergas, über ein erstes Metall ausgewählt aus der Gruppe bestehend aus Aluminium, Zirkonium, Yttrium und deren Metallsalze, bei 250°-1250°C, um ein erstes Aluminium-, Zirkonium oder Yttrium-Metallhalogenid zu bilden; und Leiten eines zweiten gasförmigen Halogenids, welches mit dem ersten gasförmigen Halogenid gleich oder von diesen verschieden sein kann, wahlweise gemischt mit einem zweiten Trägergas, welches mit dem ersten Trägergas gleich oder von diesem verschieden sein kann, über ein oder mehrere zusätzliche Metalle, ausgewählt aus der Gruppe bestehend aus Aluminium, Zirkonium, Yttrium und Legierungen und deren Metallsalze, und verschieden von dem ersten Metall, bei ungefähr 2500° - 12500°C um ein oder mehrere zusätzliche Metallhalogenide von ein oder mehreren von Aluminium, Zirkon und Yttrium zu bilden.

14. Verfahren gemäß Anspruch 13, des weiteren umfassend den Schritt des Abscheidens wenigstens einer etwa 0,5-10 Mikron dicken Zwischenschicht ausgewählt aus der Gruppe bestehend aus den Carbiden, Nitriden und Carbonitriden von Ti, Zr, Hf, V, Nb, Ta, Cr, Mo, W, Si und B zwischen dem Substrat und der Oxidschicht.

15. Verfahren gemäß Anspruch 14, wobei das erste Metall Aluminium, das zusätzliche Metall Zirkonium, das erste und zweite Halogenid Cl₂ oder HCl, und die Zwischenschicht TiC ist.

16. Verfahren nach Anspruch 15, wobei der Schritt des Leitens des ersten Halogenids über das erste Metall ein kontinuierlicher Schritt ist, um einen stetigen Fluß des ersten Metallhalogenids zu erzeugen, welches über das Substrat geleitet wird; und wobei der Schritt des Leitens des zweiten Halogenids über das eine oder die mehreren zusätzlichen Metalle ein diskontinuierlicher, pulsierender Schritt ist, um Pulse des einen oder der mehreren zusätzlichen Metallhalogenide zu erzeugen, welche mit dem ersten Metallhalogenid über das Substrat geleitet werden, wobei das zweite Halogenid unter Intervallen und über Zeiträume gepulst wird, die ausge wählt sind, um die Größe und die Verteilung der zusätzlichen Phasenteilchen innerhalb der kontinuierlichen ersten Phase zu steuern.

17. Verfahren nach Anspruch 13, wobei das erste Metallhalogenid und die anderen Reaktionsgase für einen ausreichenden Zeitraum über das Substrat geleitet werden, bevor der Durchfluß des zweiten Halogenids begonnen wird, um einen einphasigen, kontinuierlichen Bereich der Verbundschicht abzuscheiden, welcher das Substrat oder die Zwei- oder Mehrphasenbereiche von der Verbundschicht abtrennt.

18. Verfahren nach Anspruch 13, wobei der Schritt des Leitens der gasförmigen Mischung über das Substrat innerhalb eines Reaktors stattfindet; und wenigstenseines des ersten Metalls oder der ein oder mehreren zusätzlichen Metalle innerhalb eines abgetrennten Behälters in dem Reaktor angeordnet ist, wobei der abgetrennte Behälter in Betrieb mit einer Quelle der begleitenden gasförmigen Halogenide und wahlweise mit dem begleitenden Trägergas, und mit dem Reaktor in Verbindung steht, so daß das begleitende gasförmige Halogenid in den abgetrennten Behälter eintritt, und über das (die) Metall(e) in diesem geleitet wird, um das (die) Metallhalogenid(e) zu bilden, welches (welche) dann in den Reaktor fließt (fließen), um über das Substrat als ein Bestandteil der gasförmigen Mischung geleitet zu werden.

19. Verfahren nach Anspruch 18, wobei das erste Metall Aluminium oder eines dessen Metallsalze ist; und wobei das eine oder die mehreren zusätzlichen Metalle Zirkonium oder Yttrium, oder eines deren Metallsalze, oder eine Mischung oder Legierung dieser ist und innerhalb eines abgetrennten Behälters in dem Reaktor angeordnet ist.

20. Verfahren nach Anspruch 13, wobei das zusätzliche Metall Aluminium, Zirkonium, Yttrium oder ein Metallsalz dieser ist, und von dem ersten Metall verschieden ist; und des weiteren den folgenden Schritt umfaßt, Leiten eines dritten gasförmigen Halogenids, welches mit den ersten und zweiten gasförmigen Halogeniden gleich oder von diesen verschieden sein kann, wahlweise gemischt mit einem dritten Trägergas, welches mit dem ersten und zweiten Trägergas gleich oder von diesem verschieden sein kann, über ein drittes Metall ausge wählt aus der Gruppe bestehend aus Aluminium, Zirkonium, Yttrium und deren Metallsalze und das von den ersten und zusätzlichen Metallen verschieden ist, bei ungefähr 2500-12500C, um ein drittes Aluminium-, Zirkonium- oder Yttrium-Metallhalogenid zu bilden; und wobei die gasförmige Mischung, die über das Substrat geleitet wird, des weiteren das dritte Metallhalogenid umfaßt, und wobei die diskontinuierliche zusätzliche Phase zusätzlich diskrete Teilchen der Oxide von zwei ausgewählt aus Aluminium, Zirkonium und Yttrium fein verteilt in dieser aufweist.

21. Verfahren nach Anspruch 20, wobei der Schritt des Leitens der gasförmigen Mischung über das Substrat innerhalb eines Reaktors stattfindet; und wobei wenigstens eines des ersten Metalls, des zusätzlichen Metalls, und des dritten Metalls in einem abgetrennten Behälter in dem Reaktor angeordnet ist, wobei der abgetrennte Behälter wahlweise mit einer Quelle der begleitenden gasförmigen Halogenide und wahlweise dem begleitenden Trägergas und mit den Reaktor in Verbindung steht, so daß das begleitende gasförmige Halogenid in den getrennten Behälter eintritt und über das Metall in diesem geleitet wird, um das Metallhalogenid zu bilden, welches in den Reaktor fließt, um über das Substrat als ein Bestandteil der gasförmigen Mischung geleitet zu werden.

22. Verschleißbeständiges Erzeugnis umfassend:
einen Sintercarbid- oder Hartkeramiksubstratkörper;
eine vollständig dichte, haftende, verschleißbeständige, keramische Verbundschicht mit wenigstens zwei Phasen auf dem Substrat, umfassend:
eine etwa 0,1-20 Mikron dicke kontinuierliche Oxidschicht aus einem Material ausgewählt aus der Gruppe bestehend aus den Oxiden von Aluminium, Zirkonium und Yttrium; und
wenigstens eine diskontinuierliche zusätzliche Phase, welche als diskrete Teilchen innerhalb der Oxidschicht dispergiert ist, aus wenigstens einem Material, ausgewählt aus der Gruppe bestehend aus Aluminium-, Zyrkonium- und YttriumOxiden, wobei sich das wenigstens eine Material von dem der Oxidschicht unterscheidet;
dadurch gekennzeichnet, daß
die keramische Verbundschicht eine geschichtete bzw. schichtförmige Schicht ist, bei welcher sich Bereiche mit wenigstens zwei Phasen mit einphasigen kontinuierlichen Oxidschichten abwechseln.

23. Erzeugnis nach Anspruch 22, wobei der Substratkörper ein Verbund auf Si₃N₄-Basis ist, die kontinuierliche Oxidschicht Al₂O₃ ist und die zusätzliche Phase aus in dem Al₂O₃ dispergierten ZrO₂ Teilchen besteht, um zweiphasige Al₂O₃/ZrO₂ Bereiche zu bilden, die sich mit den einphasigen kontinuirlichen Al₂O₃ Bereichen abwechseln, und des weiteren umfassend, eine etwa 2 - 5 Mikron dicke Zwischenschicht aus TiC zwischen dem Substratkörper und der keramischen Verbundschicht.

24. Verschleißbeständiges Erzeugnis umfassend:
einen Sintercarbid- oder Hartkeramiksubstratkörper;
eine vollständig dichte, haftende, verschleißbeständige, keramische Verbundschicht mit wenigstens zwei Phasen auf dem Substrat, umfassend:
eine etwa 0,1-20 Mikron dicke kontinuierliche Oxidschicht aus einem Material ausgewählt aus der Gruppe bestehend aus den Oxiden von Aluminium, Zirkonium und Yttrium; und
wenigstens eine diskontinuierliche zusätzliche Phase, welche als diskrete Teilchen innerhalb der Oxidschicht dispergiert ist, aus wenigstens einem Material, ausgewählt aus der Gruppe bestehend aus Aluminium-, Zyrkonium- und YttriumOxiden, wobei das wenigstens eine Material sich von dem der Oxidschicht unterscheidet;
dadurch gekennzeichnet, daß
die kontinuierliche Oxidschicht ZrO₂ ist und die zusätzliche Phase Y₂O₃.

25. Verschleißbeständiges Erzeugnis umfassend:
einen Sintercarbid- oder Hartkeramiksubstratkörper;
eine vollständig dichte, haftende, verschleißbeständige, keramische Verbundschicht mit wenigstens zwei Phasen auf dem Substrat, umfassend:
eine etwa 0,1-20 Mikron dicke kontinuierliche Oxidschicht aus einem Material ausgewählt aus der Gruppe bestehend aus den Oxiden von Aluminium, Zirkonium und Yttrium; und
wenigstens eine diskontinuierliche zusätzliche Phase, welche als diskrete Teilchen innerhalb der Oxidschicht dispergiert ist, aus wenigstens einem Material, ausgewählt aus der Gruppe bestehend aus Aluminium-, Zyrkonium- und YttriumOxiden, wobei das wenigstens eine Material sich von dem der Oxidschicht unterscheidet;
dadurch gekennzeichnet, daß
die kontinuierliche Oxidschicht Y₂O₃ ist und die zusätzliche Phase ZrO₂.

26. Verschleißbeständiges Erzeugnis umfassend:
einen Sintercarbid- oder Hartkeramiksubstratkörper;
eine vollständig dichte, haftende, verschleißbeständige, keramische Verbundschicht mit wenigstens zwei Phasen auf dem Substrat, umfassend:
eine etwa 0,1-20 Mikron dicke kontinuierliche Oxidschicht aus einem Material ausgewählt aus der Gruppe bestehend aus den Oxiden von Aluminium, Zirkonium und Yttrium; und
wenigstens eine diskontinuierliche zusätzliche Phase, welche als diskrete Teilchen innerhalb der Oxidschicht dispergiert ist, aus wenigstens einem Material, ausgewählt aus der Gruppe bestehend aus Aluminium-, Zyrkonium- und YttriumOxiden, wobei das wenigstens eine Material sich von dem der Oxidschicht unterscheidet;
dadurch gekennzeichnet, daß
die kontinuierliche Oxidschicht Al₂O₃ ist und die zusätzliche Phase Y₂O₃ stabilisiertes ZrO₂.

27. Verschleißbeständiges Erzeugnis umfassend:
einen Sintercarbid- oder Hartkeramiksubstratkörper;
eine vollständig dichte, haftende, verschleißbeständige, keramische Verbundschicht mit wenigstens zwei Phasen auf dem Substrat, umfassend:
eine etwa 0,1-20 Mikron dicke kontinuierliche Oxidschicht aus einem Material ausgewählt aus der Gruppe bestehend aus den Oxiden von Aluminium, Zirkonium und Yttrium; und
wenigstens eine diskontinuierliche zusätzliche Phase, welche als diskrete Teilchen innerhalb der Oxidschicht dispergiert ist, aus wenigstens einem Material, ausgewählt aus der Gruppe bestehend aus Aluminium-, Zyrkonium- und YttriumOxiden, wobei das wenigstens eine Material sich von dem der Oxidschicht unterscheidet;
dadurch gekennzeichnet, daß
die kontinuierliche Oxidschicht Al₂O₃ ist und die zusätzlichen Phasen Y₂O₃ und ZrO₂.

## Revendications

1. Procédé de dépôt d'un revêtement céramique résistant à l'usure sur un substrat en carbure cémenté ou en céramique dure mettant en oeuvre un dépôt par vapeur thermique comprenant les étapes de :
passage sur le substrat d'un premier mélange gazeux d'une première vapeur d'halogénure choisi dans le groupe comprenant les halogénures d'aluminium, d'yttrium et de zirconium, avec d'autres gaz réactants et, de façon optionnelle, un gaz porteur, à une température comprise entre 900 et 1250 °C environ pour le substrat de carbure cémenté, ou entre 900 et 1500 °C environ pour le substrat de céramique dure, sous une pression comprise entre 1,33 mbar (1 Torr) et la pression ambiante, et à des taux de pression partielle, à une vitesse de circulation, et pendant un temps suffisant pour obtenir un dépôt d'une couche continue, totalement dense, adhérente et résistant à l'usure d'un matériau choisi dans le groupe comprenant l'alumine, les oxydes de zirconium et d'yttrium d'une épaisseur comprise entre 0,1 et 20 microns environ sur le substrat ;
qui comprend, en outre, l'étape de :
mélange avec le premier mélange gazeux d'au moins une vapeur additionnelle choisie parmi les halogénures d'aluminium, de zirconium et d'yttrium ;
dans lequel la vapeur additionnelle est différente de la première vapeur d'halogénure et est mélangée à pression partielle choisie pour former au moins une phase additionnelle discontinue, dispersée en particules discrètes à l'intérieur de la couche continue d'oxyde, d'au moins un matériau choisi dans le groupe comprenant l'alumine et les oxydes de zirconium et d'yttrium, pour former une couche céramique composite résistant à l'usure sur le substrat.

2. Procédé selon la revendication 1 comprenant, en outre, l'étape de dépôt entre le substrat et la couche céramique composite d'au moins une couche intermédiaire d'une épaisseur comprise entre 0,5 et 10 microns environ choisie dans le groupe comprenant les carbures, les nitrures et les carbonitrures de Ti, Zr, Hf, V, Nb, Ta, Cr, Mo, W, Si et B.

3. Procédé selon la revendication 1 dans lequel la vapeur additionnelle est propulsée dans le premier mélange gazeux pour se mélanger à ce dernier, pendant le dépôt de la couche continue d'oxyde, et dans lequel la vapeur additionnelle est choisie parmi l'halogénure d'aluminium, de zirconium et d'yttrium, optionnellement mélangé avec un gaz porteur.

4. Procédé selon la revendication 3 comprenant, en outre, l'étape de contrôle de la dimension et de la distribution à l'intérieur de la couche d'oxyde des particules de phase additionnelle par commande de la pression partielle, des intervalles de temps et des durées pendant lesquelles au moins une vapeur additionnelle est propulsée dans le premier mélange gazeux.

5. Procédé selon la revendication 4 dans lequel l'étape de dépôt de la couche continue d'oxyde est effectuée pendant un temps suffisant avant de commencer l'étape de propulsion pour former une partie continue d'oxyde en phase unique séparant le substrat et la partie en deux ou plusieurs phases du revêtement céramique composite.

6. Procédé selon la revendication 4 dans lequel l'étape de propulsion intermittente se produit à des intervalles de temps et pendant des durées choisis pour former une couche céramique composite stratifiée dans laquelle des parties en deux ou plusieurs phases alternent avec des parties continues d'oxyde en phase unique.

7. Procédé selon la revendication 3 comprenant, en outre, l'étape de dépôt entre le substrat et la couche céramique composite d'au moins une couche intermédiaire d'épaisseur comprise entre 0,5 et 10 microns choisie dans le groupe comprenant les carbures, les nitrures et les carbonitrures de Ti, Zr, Hf, V, Nb, Ta, Cr, Mo, W, Si et B.

8. Procédé selon la revendication 3 comprenant, en outre, l'étape de dépôt entre le substrat et la couche céramique composite d'une couche intermédiaire de TiC ou de TiN d'une épaisseur comprise entre 2 et 5 microns environ; et dans lequel le premier mélange gazeux comprend essentiellement entre 2,5 et 21 % en volume de CO₂, entre 47 et 64 % en volume d'hydrogène et entre 1,5 et 30 % en volume d'AlCl₃, le reste étant de l'argon, passant sur le substrat à une température comprise entre 1000 et 1100 °C, une pression comprise entre 66,5 et 133 mbar (entre 50 et 100 Torr), et une vitesse comprise entre 1100 et 1500 cm³/mn pendant un temps compris entre 2,5 et 5 heures ; et la au moins une vapeur additionnelle comprend entre 0,5 et 2,5 % en volume de ZrCl₄ propulsé pendant un temps compris entre 1 et 10 minutes environ à des intervalles de temps compris entre 2 et 6 fois la durée de propulsion, pour déposer une couche céramique composite comprenant une première phase continue d'Al₂O₃ et une phase additionnelle discontinue de particules discrètes de ZrO₂ dispersées à l'intérieur de la première phase d'Al₂O₃.

9. Procédé selon la revendication 8 dans lequel la couche intermédiaire est du TiC présentant une épaisseur comprise entre 3,0 et 3,5 microns environ ; le premier mélange gazeux comprend essentiellement 7 % en volume de CO₂, 88 % en volume d'hydrogène, 2,5 % en volume d'AlCl₃, environ, le reste étant de l'argon, passant sur le substrat à une température de 1040 °C environ, une pression de 66,5 mbar environ (50 Torr), et une vitesse de 1420 cm³/mn environ pendant 3,5 heures environ; et 2,5 % environ en volume de ZrCl₄ sont propulsés pendant environ 8 minutes toutes les 22 minutes pendant au moins 2,5 heures.

10. Procédé selon la revendication 1 comprenant, en outre, les étapes suivantes :
passage d'une vapeur d'halogénure, optionnellement mélangée avec un gaz porteur, sur un mélange ou alliage de deux ou plusieurs métaux choisis dans le groupe comprenant l'aluminium, le zirconium, l'yttrium et leurs sels métalliques, à une température comprise entre 250 et 1250 °C environ, pour former un premier mélange d'halogénures comprenant des halogénures de deux ou plusieurs métaux d'aluminium, de zirconium et d'yttrium, et, optionnellement, le gaz porteur ; et
mélange du premier mélange d'halogénures avec d'autres gaz réactants pour former un premier mélange gazeux.

11. Procédé selon la revendication 10 dans lequel le mélange ou alliage de deux ou plusieurs métaux consiste essentiellement en un mélange ou alliage d'aluminium et de zirconium ou un mélange ou alliage de zirconium et d'yttrium ; l'autre gaz réactant comprend du CO₂ avec de l'hydrogène comme porteur ; et la couche composite comprend une première phase continue d'Al₂O₃ dans laquelle sont dispersées des particules discrètes de ZrO₂, ou une première phase continue de ZrO₂ ayant des particules discrètes d'Y₂O₃, ou une première phase continue de Y₂O₃ dans laquelle sont dispersées des particules discrètes de ZrO₂.

12. Procédé selon la revendication 10 comprenant, en outre, l'étape de dépôt entre le substrat et la couche céramique composite en au moins une couche intermédiaire d'une épaisseur comprise entre 0,5 et 10 microns choisie dans le groupe comprenant les carbures, les nitrures et les carbonitrures de Ti, Zr, Hf, V, Nb, Ta, Cr, Mo, W, Si et B.

13. Procédé selon la revendication 1 comprenant, en outre, les étapes suivantes :
premier passage d'un premier halogénure gazeux, optionnellement mélangé à un premier gaz porteur, sur un premier métal choisi dans le groupe comprenant l'aluminium, le zirconium, l'yttrium et les sels métalliques de ces derniers, à une température comprise entre 250 et 1250 °C, pour former un premier halogénure métallique gazeux d'aluminium, de zirconium ou d'yttrium; et
passage d'un deuxième halogénure gazeux, qui peut être le même ou être différent du premier halogénure gazeux, optionnellement mélangé à un deuxième gaz porteur, qui peut être identique ou différent du premier gaz porteur, sur un ou plusieurs métaux additionnels choisis dans le groupe comprenant l'aluminium, le zirconium, l'yttrium et les alliages et sels métalliques de ceux-ci, et différents du premier métal, à une température comprise entre 250 et 1250 °C environ, de manière à former un ou plusieurs halogénures métalliques additionnels de l'un ou plusieurs de l'aluminium, le zirconium et l'yttrium.

14. Procédé selon la revendication 13 comprenant, en outre, l'étape de dépôt entre le substrat et la couche d'oxyde d'au moins une couche intermédiaire d'une épaisseur comprise entre 0,5 et 10 microns, choisie dans le groupe comprenant les carbures, les nitrures et les carbonitrures de Ti, Zr, Hf, V, Nb, Ta, Cr, Mo, W, Si et B.

15. Procédé selon la revendication 14 dans lequel le premier métal est de l'aluminium, le métal additionnel est du zirconium, les premier et deuxième halogénures sont à, la fois, Cl₂ ou HCl, et la couche intermédiaire est du TiC.

16. Procédé selon la revendication 15 dans lequel l'étape de passage du premier halogénure sur le premier métal est une étape continue, produisant un flux ininterrompu du premier halogénure métallique passant sur le substrat ; et l'étape de passage du deuxième halogénure sur un ou plusieurs métaux additionnels est une étape intermittente par impulsions produisant des impulsions de un ou plusieurs halogénures métalliques passant sur le substrat avec le premier halogénure métallique, dans lequel le deuxième halogénure est pulsé à des intervalles de temps et des durées choisis pour contrôler la taille et la distribution des particules en phase additionnelle à l'intérieur de la première phase continue.

17. Procédé selon la revendication 13 dans lequel le premier halogénure métallique et les autres gaz réactants sont passés sur le substrat pendant un temps suffisant avant que le flux du deuxième halogénure commence le dépôt d'une partie continue en phase unique de la couche composite séparant le substrat et la partie en deux ou plusieurs phases de la couche composite.

18. Procédé selon la revendication 13 dans lequel l'étape de passage du mélange gazeux sur le substrat est effectuée à l'intérieur d'un réacteur ; et au moins un du premier métal et du ou des métaux additionnels est disposé à l'intérieur d'un récipient séparé à l'intérieur du réacteur, le récipient séparé communiquant de façon optionnelle avec une source de l'halogénure gazeux associée et, optionnellement du gaz porteur associé, et avec le réacteur, de manière que l'halogénure gazeux associé pénètre dans le récipient séparé et traverse le ou les métaux qu'il enferme pour former le ou les halogénures métalliques, qui circulent à l'intérieur du réacteur pour passer sur le substrat en tant que composant du mélange gazeux.

19. Procédé selon la revendication 18 dans lequel le premier métal est de l'aluminium ou un sel métallique de celui-ci ; et (le ou) les métaux additionnels sont le zirconium ou l'yttrium ou un sel métallique de ceux-ci, ou un mélange ou un alliage de ceux-ci, et sont disposés à l'intérieur d'un récipient séparé à l'intérieur du réacteur.

20. Procédé selon la revendication 13 dans lequel le métal additionnel est de l'aluminium, du zirconium, de l'yttrium ou un sel métallique de ceux-ci, et est différent du premier métal ; et comprenant, en outre, l'étape de passage d'un troisième halogénure gazeux, qui peut être identique ou différent des premier et deuxième halogénures gazeux, optionnellement mélangé avec un troisième gaz porteur, qui peut être identique ou différent des premier et deuxième gaz porteurs, sur un troisième métal choisi dans le groupe comprenant l'aluminium, le zirconium, l'yttrium et les sels métalliques de ceux-ci, et différent des premier et additionnel métaux, à une température comprise entre 250 et 1250 °C environ, pour former un troisième halogénure métallique d'aluminium, de zirconium ou d'yttrium ; et dans lequel le mélange gazeux passant sur le substrat comprend le troisième halogénure métallique, et la phase additionnelle discontinue comprend, en outre, des particules discrètes d'oxydes de deux des aluminium, zirconium et yttrium dispersées dedans.

21. Procédé selon la revendication 20 dans lequel l'étape de passage du mélange gazeux sur le substrat est effectuée à l'intérieur d'un réacteur ; et au moins un des premier, additionnel et troisième métaux est déposé à l'intérieur d'un récipient séparé à l'intérieur du réacteur, le récipient séparé pouvant optionnellement communiquer avec une source de l'halogénure gazeux associé et, optionnellement, du gaz porteur associé, et avec le réacteur, de telle manière que l'halogénure gazeux associé pénètre dans le récipient séparé et passe sur le métal à l'intérieur pour former l'halogénure métallique, qui circule dans le réacteur pour passer sur le substrat en tant que composant du mélange gazeux.

22. Article résistant à l'usure comprenant :
un corps de substrat en carbure cémenté ou en céramique dure ; et
un revêtement céramique composite totalement dense et adhérent, résistant à l'usure, présentant au moins deux phases sur le substrat comprenant :
une couche continue d'oxyde d'une épaisseur comprise entre 0,1 et 20 microns environ d'un matériau choisi dans le groupe comprenant l'alumine, les oxydes de zirconium et d'yttrium ; et
au moins une phase additionnelle discontinue dispersée en tant que particules discrètes à l'intérieur de la couche d'oxyde, d'au moins un matériau choisi dans le groupe comprenant l'alumine et les oxydes de zirconium et d'yttrium, le au moins un matériau étant différent de celui de la couche d'oxyde ;
**caractérisé en ce que**
la couche céramique composite est une couche stratifiée dont des parties ont au moins deux phases alternées avec des parties continues d'oxyde en phase unique.

23. Article selon la revendication 22 dans lequel le corps du substrat est un composite à base de Si₃N₄, la couche continue d'oxyde est de l'Al₂O₃, et la phase additionnelle est constituée par des particules de ZrO₂ dispersées à l'intérieur de l'Al₂O₃ pour former des parties alternées en deux phases Al₂O₃/ZrO₂ avec des parties continues d'Al₂O₃ en phase unique, et comprenant, en outre, une couche intermédiaire de TiC d'une épaisseur comprise entre 2 et 5 microns environ entre le corps du substrat et la couche de céramique composite.

24. Article résistant à l'usure comprenant :
un corps de substrat en carbure cémenté ou en céramique dure ; et
un revêtement céramique composite totalement dense et adhérent, résistant à l'usure, présentant au moins deux phases sur le substrat comprenant :
une couche continue d'oxyde d'une épaisseur comprise entre 0,1 et 20 microns environ d'un matériau choisi dans le groupe comprenant l'alumine, les oxydes de zirconium et d'yttrium ; et
au moins une phase additionnelle discontinue dispersée en tant que particules discrètes à l'intérieur de la couche d'oxyde, d'au moins un matériau choisi dans le groupe comprenant l'alumine et les oxydes de zirconium et d'yttrium, le au moins un matériau étant différent de celui de la couche d'oxyde ;
**caractérisé en ce que**
la couche continue d'oxyde est du ZrO₂ et la phase additionnelle est de l'Y₂O₃.

25. Article résistant à l'usure comprenant :
un corps de substrat en carbure cémenté ou en céramique dure ; et
un revêtement céramique composite totalement dense et adhérent, résistant à l'usure, présentant au moins deux phases sur le substrat comprenant :
une couche continue d'oxyde d'une épaisseur comprise entre 0,1 et 20 microns environ d'un matériau choisi dans le groupe comprenant l'alumine, les oxydes de zirconium et d'yttrium ; et
au moins une phase additionnelle discontinue dispersée en tant que particules discrètes à l'intérieur de la couche d'oxyde, d'au moins un matériau choisi dans le groupe comprenant l'alumine et les oxydes de zirconium et d'yttrium, le au moins un matériau étant différent de celui de la couche d'oxyde ;
**caractérisé en ce que**
la couche continue d'oxyde est de l'Y₂O₃ et la phase additionnelle est du ZrO₂.

26. Article résistant à l'usure comprenant :
un corps de substrat en carbure cémenté ou en céramique dure ; et
un revêtement céramique composite totalement dense et adhérent, résistant à l'usure, présentant au moins deux phases sur le substrat comprenant :
une couche continue d'oxyde d'une épaisseur comprise entre 0,1 et 20 microns environ d'un matériau choisi dans le groupe comprenant l'alumine, les oxydes de zirconium et d'yttrium ; et
au moins une phase additionnelle discontinue dispersée en tant que particules discrètes à l'intérieur de la couche d'oxyde, d'au moins un matériau choisi dans le groupe comprenant l'alumine et les oxydes de zirconium et d'yttrium, le au moins un matériau étant différent de celui de la couche d'oxyde ;
**caractérisé en ce que**
la couche continue d'oxyde est de l'Al₂O₃ et la phase additionnelle est du ZrO₂ stabilisé avec de l'Y₂O₃.

27. Article résistant à l'usure comprenant :
un corps de substrat en carbure cémenté ou en céramique dure ; et
un revêtement céramique composite totalement dense et adhérent, résistant à l'usure, présentant au moins deux phases sur le substrat comprenant :
une couche continue d'oxyde d'une épaisseur comprise entre 0,1 et 20 microns environ d'un matériau choisi dans le groupe comprenant l'alumine, les oxydes de zirconium et d'yttrium ; et
au moins une phase additionnelle discontinue dispersée en tant que particules discrètes à l'intérieur de la couche d'oxyde, d'au moins un matériau choisi dans le groupe comprenant l'alumine et les oxydes de zirconium et d'yttrium, le au moins un matériau étant différent de celui de la couche d'oxyde ;
**caractérisé en ce que**
la couche continue d'oxyde est de l'Al₂O₃ et la phase additionnelle comprend des particules de ZrO₂ et de Y₂O₃.
